Europäisches Patentamt

(19) European Patent Office

Office européen des brevets

(11) Numéro de publication : **0 346 333 B1**

# (12) FASCICULE DE BREVET EUROPEEN

(45) Date de publication du fascicule du brevet :
04.12.91 Bulletin 91/49

(51) Int. Cl.⁵ : **G01R 33/38**

(21) Numéro de dépôt : **88900461.0**

(22) Date de dépôt : **23.12.87**

(86) Numéro de dépôt international :
**PCT/FR87/00512**

(87) Numéro de publication internationale :
**WO 88/05167 14.07.88 Gazette 88/15**

(54) **DISPOSITIF CORRECTEUR PAR ELEMENTS MAGNETIQUES D'INHOMOGENEITES DU CHAMP MAGNETIQUE DANS UN AIMANT.**

(30) Priorité : 30.12.86 FR 8618358

(43) Date de publication de la demande :
20.12.89 Bulletin 89/51

(45) Mention de la délivrance du brevet :
04.12.91 Bulletin 91/49

(84) Etats contractants désignés :
DE GB IT NL

(56) Documents cités :
EP-A- 0 222 281
EP-A-01 510 36
JP-A-61 264 242
Patent Abstracts of Japan, vol.9, No:174
(P-374)(1897) 19 July 1985, & JP, A,60-50442

(73) Titulaire : **GENERAL ELECTRIC CGR S.A.**
**100, rue Camille-Desmoulins**
**F-92130 Issy les Moulineaux (FR)**

(72) Inventeur : **AUBERT, Guy**
**26, cours de la Libération**
**F-38100 Grenoble (FR)**

(74) Mandataire : **Schmit, Christian Norbert Marie**
**et al**
**Cabinet Ballot-Schmit 7, rue Le Sueur**
**F-75116 Paris (FR)**

## Description

La présente invention est due à la collaboration du Service National des Champs Intenses (Directeur M. Guy AUBERT), et elle a pour objet un dispositif correcteur par éléments magnétiques des inhomogénéités du champ magnétique produit par un aimant. Elle concerne particulièrement des moyens de montage et de positionnement d'un ou plusieurs de ces éléments magnétiques. L'invention trouve son application particulièrement dans le domaine médical où des aimants sont utilisés dans des méthodes d'imagerie par résonance magnétique nucléaire. Elle peut néanmoins trouver son application dans d'autres domaines, notamment dans celui de la recherche scientifique où des champs intenses produits par des aimants sont utilisés.

La résonance magnétique est un phénomène d'oscillation du moment magnétique des noyaux des atomes ou molécules d'un corps, à une fréquence qui dépend de l'intensité d'un champ magnétique dans lequel baigne ce corps. Il en ressort que si l'intensité du champ magnétique varie, la fréquence du phénomène de résonance varie également. Aussi, pour des raisons technologiques et techniques, il est de la plus haute importance que le champ produit par l'aimant soit très homogène dans sa zone d'intérêt. L'homogénéité requise est couramment de l'ordre de quelques parties par million dans le domaine médical, voire de quelques parties par milliard dans le domaine scientifique. Pour arriver à ce but, on essaye de construire des aimants donnant un champ le plus parfaitement homogène.

Malheureusement, quel que soit le soin apporté à la construction des aimants, leur réalisation n'est jamais aussi parfaite que la théorie qui a conduit à leur calcul. Par ailleurs, même si ce défaut peut être, l'aimant pour être utilisé doit matériellement être placé en un endroit donné. Or aucune des régions de l'espace, dans un environnement industriel ou urbain, n'est totalement exempte d'éléments magnétiques perturbateurs. Il en résulte qu'un fois l'aimant installé sur le site, le champ qu'il produit dans une zone d'intérêt présente des inhomogénéités qu'il est nécessaire de corriger.

Le principe de la correction des inhomogénéités de champs est celui de la superposition : on ajoute des bobines, des pièces magnétiques, ou tous autres moyens permettant de corriger les imperfections du champ principal et d'obtenir un champ global homogène dans la zone d'intérêt. Une méthode connue, pour corriger les inhomogénéités du champ magnétique produit par un aimant, consiste à utiliser des éléments magnétiques tels que des barres aimantables, par exemple en fer doux, que l'on place dans l'environnement de l'aimant, et qui exercent leur influence dans une zone d'intérêt de l'aimant de manière à corriger les inhomogénéités du champ dans cette zone.

Un tel procédé est commenté dans un article de Revue Sci. Instrum. de JANVIER 1985, dû à MM. D.I. HOULT, et D. LEE, intitulé "Shimming a superconducting nuclear-magnetic-resonance imaging magnet with steel", page 131 à 135. L'article se rapporte particulièrement a un aimant pour appareil d'imagerie par résonance magnétique nucléaire. L'aimant a la forme d'un cylindre circulaire, à l'intérieur duquel est située la zone d'intérêt dont le centre est placé sur l'axe de l'aimant ; le champ magnétique produit par l'aimant étant à l'intérieur de ce dernier sensiblement parallèle à l'axe de l'aimant. Ce document décrit en détail une méthode de calcul qui permet de déterminer les dimensions et la position d'une ou de plusieurs barres magnétiques d'acier doux autour de l'axe de l'aimant, en fonction d'un point du volume d'intérêt ou une inhomogénéité du champ est à corriger ; la longueur de ces barres magnétiques correctrices étant parallèle à l'axe de l'aimant.

Un tel procédé, malgré sa relative complexité, permet de corriger efficacement des inhomogénéités que peut comporter le champ magnétique dans le volume d'intérêt, en disposant une ou des barres magnétiques correctrices dont la section, la longueur et la position par rapport au volume d'intérêt sont déterminées sur la base des calculs connus, et tels que par exemple indiqués notamment dans l'article ci-dessus mentionné. Mais tel qu'il est connu, ce procédé présente l'inconvénient d'être difficilement applicable dans le cadre d'une fabrication industrielle d'aimants : en effet, compte tenu particulièrement, d'une part des tolérances de fabrication qui peuvent introduire d'un aimant à l'autre des différences entre les champs magnétiques produits par ces aimants, et compte tenu d'autre part, des éléments qui sur le site d'installation sont susceptibles de perturber le champ magnétique, il est nécessaire de rédéfinir à la fois la longueur, la section transversale et la position des barres magnétiques correctrices quand l'aimant est déjà installé sur le site, c'est-à-dire que les barres magnétiques doivent être taillées et positionnées sur mesure pour chaque application. Le document EP-A-0 222 281 date de priorité :12.11.85 ; date de publication :20.05.87 ; art antérieur selon l'article 54(3) CBE décrit une simplification de ce problème en ce qu'il prévoit des ouvertures pratiquées dans des bagues parallèles, espacées les unes des autres et destinées à recevoir des éléments magnétiques longitudinaux de corrections.

La présente invention concerne un dispositif correcteur d'inhomogénéité du champ magnétique produit par un aimant, permettant d'appliquer le principe ci-dessus expliqué de la correction du champ par une ou des barres magnétiques, sur la base des calculs connus, et elle a particulièrement pour objet de faciliter la mise en oeuvre de ce principe sur le site d'installation de l'aimant, afin notamment de le rendre applicable dans le cadre d'une production industrielle.

Ceci est obtenu avec le dispositif de correction selon l'ivention par un agencement nouveau réalisé lors d'une phase de construction ou de montage de l'aimant, et qui, d'une part, prévoit les possibles positions d'un ou plusieurs éléments magnétiques correcteurs ou barres magnétiques et qui d'autre part, permet aisément sur le site d'installation d'ajuster le degré d'influence de la ou des barres magnétiques.

Selon l'invention, un dispositif correcteur d'inhomogénéités d'un champ magnétique dans un aimant, comportant au moins un élément magnétique de forme allongée dont la longueur et la section transversale sont définies en fonction de le correction à effectuer, un support portant l'élément magnétique dans une ouverture à proximité du champ à corriger, est caractérisé en ce que l'ouverture est formée par un emplacement réservé lors de la construction du support, l'ouverture ayant une longueur et une section transversales égales ou supérieures respectivement à une longueur maximale et à une section transversale maximale de l'élément magnétique, et en ce qu'il comporte en outre des moyens pour maintenir sensiblement confondus l'axe longitudinal de l'élément magnétique avec l'axe longitudinal de l'ouverture.

L'invention sera mieux comprise grâce à la description qui suit, faite à titre d'exemple non limitatif, et aux deux figures annexées, parmi lesquelles:

    – la figure 1 représente schématiquement, par une vue en perspective, un appareil d'imagerie par résonance magnétique nucléaire incorporant un dispositif correcteur d'inhomogénéité conforme à l'invention;

    – la figure 2 est une vue en coupe longitudinale de l'appareil d'IRM et permet de représenter des détails caractéristiques du dispositif correcteur de l'invention.

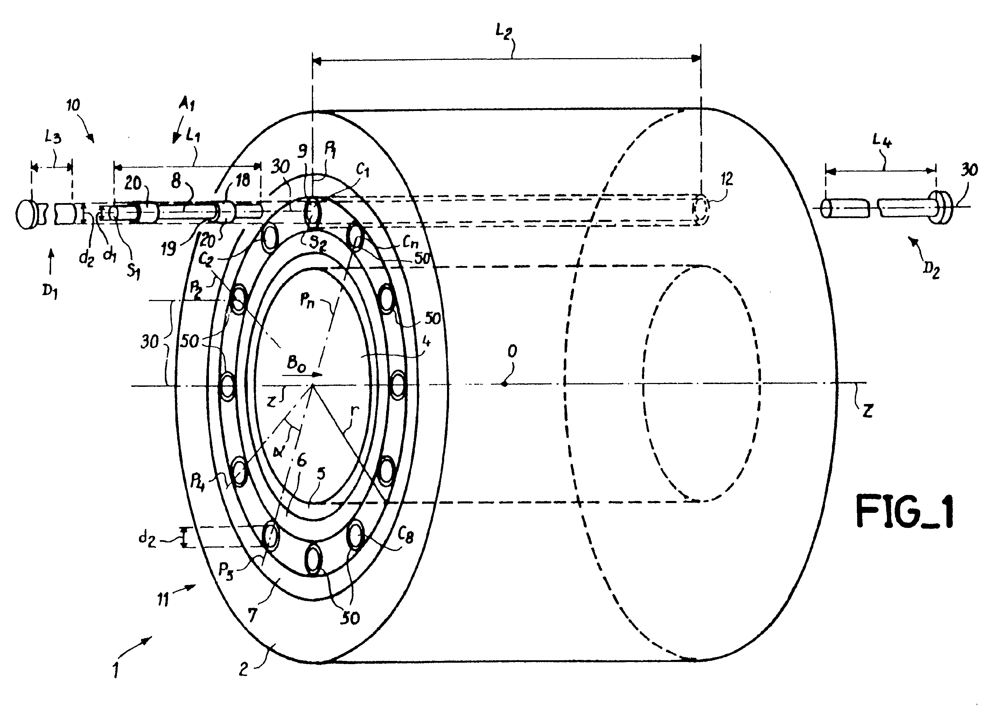

La figure 1 montre à titre d'exemple non limitatif, une application d'un dispositif correcteur 10 selon l'invention, à la correction d'inhomogénéités de champ d'un appareil 1 d'imagerie par résonance magnétique nucléaire ou, appareil d'IRM ; la représentation de l'appareil 1 d'IRM étant limitée aux éléments nécessaires à comprendre l'invention. L'appareil d'IRM 1 a la forme générale d'un cylindre circulaire et comporte un aimant 2 de forme cylindrique également, dont l'axe Z constitue également l'axe longitudinal de l'appareil d'IRM 1 ; l'aimant 2 étant constitué par exemple par un agencement de bobines électriques (non représentées ) de type connu. L'aimant 2 produit un champ magnétique $B_O$ qui est orienté, à l'intérieur de l'aimant 2, selon l'axe Z de ce dernier. Le long de l'axe Z de l'aimant, un espace intérieur libre 4 constitue un tunnel destiné à recevoir un patient (non représenté) à examiner. Selon un arrangement traditionnel, l'appareil d'IRM 1 comporte autour du tunnel 4 différents éléments qui apparaissent, sur la figure 1, à une extrémité 11 de l'appareil d'IRM 1 selon plusieurs couches coaxiales 5, 6, 7, 2 :

la première couche 5, la plus près de l'axe Z de l'aimant, représente la place occupée par des bobines ou antennes radiofréquence classiques (non représentées) ; la seconde couche 6 qui entoure la première couche 5, symbolise la place occupée par des bobines de gradients classiques ( non représentées ) ; dans l'exemple non limitatif décrit, une troisième couche périphérique 7 représente la place occupée par des bobines de correction de champ de type connu (non représentées) et la dernière couche 2 représente l'aimant. Les bobines de correction 7 permettent de corriger de manière classique des inhomogénéités du champ $B_O$ dans l'aimant 2, dans une zone d'intérêt (non représentée) dont le centre O est sur l'axe Z de l'aimant, en ajustant l'intensité du courant qui leur est appliqué. Ces bobines 7 permettent d'effectuer des corrections très fines, mais dans certains cas leur efficacité est diminuée par le fait que leur position est figée.

L'appareil d'IRM 1 comporte en outre le dispositif correcteur 10, permettant de corriger des inhomogénéités du champ $B_O$ à l'aide d'au moins un élément magnétique A1 qui peut être aussi bien du type aimantable (aimantation temporaire), c'est-à-dire en matériau magnétique doux comme par exemple en ferrite doux ou en fer doux, ou du type aimanté (aimant permanent). Dans l'exemple non limitatif décrit, un unique élément magnétique A1 ayant la forme d'une barre est représenté sur la figure 1, qui est destiné à être logé dans une ouverture C1 dans l'appareil d'IRM 1 afin d'agir sur le champ $B_O$, particulièrement dans la zone d'intérêt située dans l'espace intérieur 4 et dont le centre O est sur l'axe Z de l'aimant. Ainsi qu'il est expliqué dans une suite de la description, le dispositif correcteur 10 peut néanmoins comporter plusieurs ouvertures et plusieurs éléments magnétiques ou barres magnétiques, particulièrement dans le cas d'une application à un appareil d'IRM.

Le dispositif correcteur 10 comporte en outre des moyens 20, D1, D2 permettant de positionner de manière précise la barre magnétique A1, par rapport par exemple au centre d'intérêt O. Dans l'exemple non limitatif décrit, l'ouverture C1 comporte un axe longitudinal 30 parallèle à l'axe Z de l'aimant, et elle est située à l'intérieur de l'aimant 2, c'est-à-dire entre les bobines de correction de type connu représentées par la troisième couche 7 et la seconde couche 6 qui représente les bobines de gradients précédemment mentionnées ; la barre ou élément magnétique A1 étant, dans l'exemple non limitatif décrit, du type aimantable. L'appareil d'IRM 1 constitue ainsi le support de la barre ou élément magnétique A1, mais l'ouverture C1 pourrait aussi bien être réalisée à une autre position, par exemple extérieure par rapport à l'aimant 2, et réalisée dans un support différent (non représenté).

Selon une caractéristique de l'invention, l'ouverture C1 est réalisée de construction, c'est-à-dire qu'elle est formée à une position prédéterminée P1 par un emplacement réservé à cet effet lors de la construction de l'appareil d'IRM 1.

La longueur L1 et/ou la section S1 de la barre magnétique A1 sont susceptibles de varier d'un aimant à un autre en fonction de l'inhomogénéité du champ $B_O$ à corriger. Pour tenir compte de cette possibilité, il est conféré à l'ouverture C1, d'une part, une seconde section transversale S2 égale ou supérieure à la section transversale maximum que peut comporter la barre magnétique A1, et d'autre part, une seconde longueur L2 égale ou supérieure à la longueur maximum que peut comporter une barre magnétique ou élément magnétique A1.

Selon selon une autre caractéristique de l'invention, les moyens de positionnement comportent au moins une cale radiale 20 dans laquelle est engagée la barre magnétique A1. La ou les cales radiales 20 constituent des moyens pour maintenir la barre magnétique A1 dans l'ouverture C1 de manière que l'axe longitudinal 30 de cette dernière soit confondu avec un axe longitudinal 8 de la barre magnétique A1.

La forme des sections transversales S1, S2 de la barre magnétique A1 et de l'ouverture C1 peut être quelconque, par exemple carrée ou rectangulaire, ou circulaire ainsi que dans l'exemple représenté à la figure 1, où la section circulaire S1 de la barre magnétique A1 comporte un premier diamètre d1 inférieur au second diamètre d2 que comporte la section circulaire S2 de l'ouverture C1. La section maximum que peut comporter un élément ou barre magnétique A1 correspond au diamètre d2 de l'ouverture C1, et la seconde longueur L2 de cette dernière représente la longueur maximum que peut comporter une barre magnétique A1. Dans l'exemple non limitatif décrit, la seconde longueur L2 de l'ouverture C1 correspond à la longueur de l'appareil d'IRM 1, de sorte que les deux extrémités 9, 12 de l'ouverture C1 sont accessibles.

Les moyens 20, pour maintenir aligné les axes longitudinaux 8,30 de la barre magnétique A1 et de l'ouverture C1, sont réalisés en un matériau n'ayant pas d'influence sur un champ magnétique, comme les résines époxy ou la fibre de verre par exemple. Ces moyens peuvent être constitués de différentes manières, l'essentiel étant de maintenir la barre magnétique A1 dans l'ouverture C1 de sorte que leur axe longitudinal respectif 8,30 soient sensiblement confondus quelles que soient les formes des sections transversales S1, S2, et particulièrement quand la section S1 de la barre magnétique A1 est inférieure à celle de l'ouverture C1. Dans l'exemple non limitatif décrit, ces moyens sont constitués par les cales radiales 20, formées chacune à partir d'un disque circulaire ayant une ouverture axiale 19 au même diamètre d1 que la barre magnétique A1 utilisée, et dont la forme extérieure 18 représentée par le diamètre extérieur correspond au second diamètre d2 de l'ouverture C1.

Les moyens de positionnement comportent en outre des cales longitudinales D1,D2 destinées à être montées dans l'ouverture C1, de part et d'autre de la barre magnétique A1, afin de bloquer cette dernière à la position qu'elle doit occuper le long de l'axe Z de l'aimant. Ainsi par exemple, si la longueur L1 que doit comporter la barre magnétique A1 est de 0,31 m, et si cette longueur L1 doit être centrée par rapport au centre d'intérêt O lui-même au centre de l'appareil d'IRM 1, la seconde longueur L2 de ce dernier étant par exemple de deux mètres : la première et la seconde cales longitudinales D1,D2 ont des longueurs L3,L4 égales, chacune de 0,845 mètres, c'est-à-dire que l'addition des longueurs L1, L3, L4 correspond à la seconde longueur L2 de l'ouverture C1 ; si la position de la barre magnétique A1 doit être décentrée par rapport au centre d'intérêt O, plus près de la première extrémité 9 de l'ouverture C1 par exemple, la longueur L3 de la première cale longitudinale D1 est diminuée et la longueur L4 de la seconde cale longitudinale D2 est augmentée.

Selon une autre caractéristique de l'invention, le dispositif correcteur 10 comporte une pluralité d'ouvertures C1, C2, . . . , Cn, semblables à la première ouverture C1, et réalisées de construction comme cette dernière lors de l'assemblage de l'appareil d'IRM 1. Il est à noter qu'il est relativement simple de réserver les emplacements destinés aux ouvertures C1,..., Cn en disposant à ces emplacements des fourreaux ou des tubes 50 en matériau amagnétique, en fibre de verre par exemple. Les ouvertures C1,..., Cn sont disposées de manière symétrique selon un même cercle de rayon r, autour de l'axe Z de l'aimant, et comportent des axes longitudinaux 30 parallèles à ce dernier. Chacune de ces ouvertures C1 à Cn peut comporter ou non une barre magnétique A1, dans les mêmes conditions que celles décrites en référence à la première ouverture C1 ; c'est-à-dire que pour chaque barre magnétique disposée dans l'une de ces ouvertures C1 à Cn, il est utilisé un jeu de cales longitudinales semblables aux cales longitudinales D1,D2, et il peut être utilisé des cales radiales 20 adaptées au diamètre d1 de la barre magnétique quand cette dernière comporte un premier diamètre d1 inférieur au second diamètre d2 de l'ouverture C1,..., Cn utilisée.

Dans l'exemple non limitatif de la description, les ouvertures C à Cn sont placées à des positions angulaires prédéterminées P1,...,Pn distribuées autour de l'axe Z de l'aimant selon des angles α de 30°, c'est-à-dire que 12 ouvertures ont ainsi été réalisées ; mais dans l'esprit de l'invention, le nombre de ces ouvertures peut être différent, de même que leur position angulaire P1 à Pn et leur distance par rapport à l'axe Z de l'aimant représentée par le rayon r.

Le champ magnétique $B_O$ ayant été mesuré d'une manière en elle-même connue, les inhomogénéités du champ $B_O$ peuvent être corrigées à l'aide d'une ou plusieurs barres magnétiques A1,..., An dont le nombre N est limité uniquement par celui des ouvertures C1 à Cn. Après avoir déterminé, soit par des essais, soit à l'aide d'un logiciel mettant en oeuvre des calculs classiques, pour chaque barre magnétique : sa position angulaire P1 à Pn correspondant à l'une des ouvertures C1 à Cn ; sa longueur L1 ; sa section transversale S1 et sa position longitudinale le long de l'axe Z de l'aimant, chaque barre magnétique A1,AN est mise en place dans l'ouverture C1 à Cn qui lui est affectée, les barres magnétiques pouvant être en nombre inférieur à celui des ouvertures.

Cet agencement du dispositif correcteur 10 selon l'invention permet d'appliquer le principe de la correction des inhomogénéités du champ $B_O$ par une, ou des barres magnétiques ou éléments magnétiques A1, AN d'une manière beaucoup plus simple et plus rapide que dans l'art antérieur, grâce notamment à l'existence des ouvertures C1 à Cn pré-usinées, et par l'utilisation des cales longitudinales D1, D2 et des cales radiales 20 qui facilitent le positionnement précis des barres magnétiques A1,..., AN. Il est à noter que le réglage et les calculs sont considérablement simplifiés du fait que l'axe longitudinal 8 d'une barre magnétique A1,AN conserve toujours une même position connue quelque soit la dimension de la section transversale S1 de la barre magnétique, cette position connue étant celle de l'axe longitudinal 30 de l'ouverture C1 à Cn dans laquelle est engagée la barre magnétique.

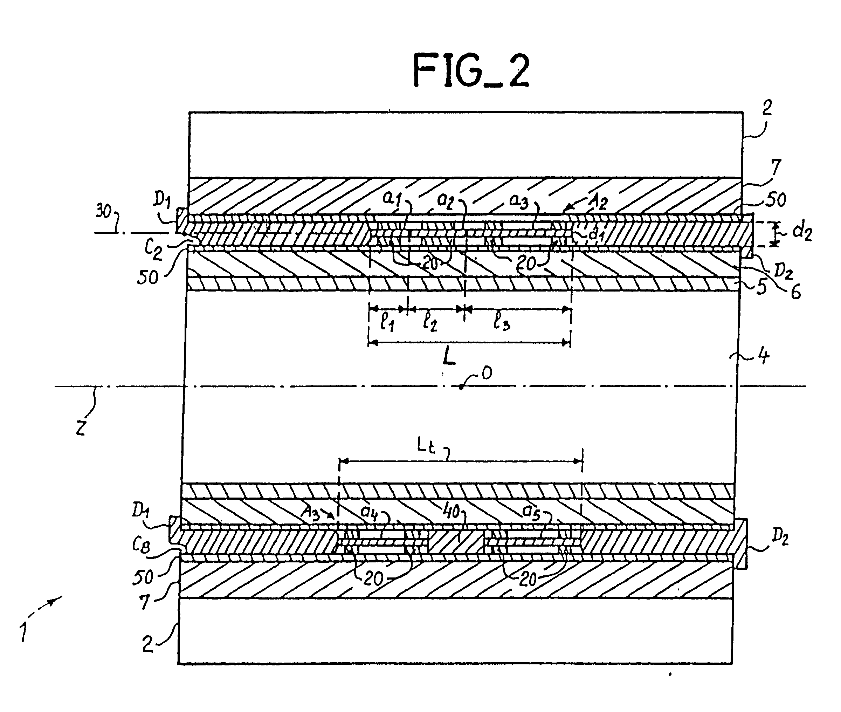

Selon une autre caractéristique de l'invention, la longueur L1 de chaque barre magnétique A1, AN peut être formée par deux ou plus tronçons magnétiques mis bout à bout, comme il est représenté sur la figure 2, afin de faciliter sur le plan pratique les réglages sur le site d'installation.

La figure 2 représente l'appareil d'IRM 1 par une vue en coupe longitudinale selon l'axe Z de l'aimant, et montre en coupe comme exemple, la seconde ouverture C2 et la huitième ouverture C8 montrées sur la figure 1, et qui sont opposées par rapport à l'axe Z de l'aimant.

La seconde et huitième ouvertures C2, C8 sont formées par l'intérieur d'un tube 50, et contiennent respectivement une seconde et une troisième barres magnétiques A2, A3 disposées chacune entre une première et une seconde cales longitudinales D1, D2. La longueur L1 exigée pour la seconde barre A2 peut être obtenue par une barre magnétique taillée d'une seule pièce, ou, ainsi que dans l'exemple non limitatif représenté sur la figure 2, par plusieurs tronçons magnétiques a1,a2,a3 mis bout à bout de sorte à constituer une unique barre magnétique A2 ayant la longueur L1 désirée ; les premier, second et troisième tronçons a1,a2,a3 peuvent comporter une même longueur, ou ainsi que dans l'exemple de la figure 2 comporter respectivement des longueurs élémentaires 11, 12, 13 différentes, par exemple 6, 10 et 15 cm. Il est ainsi possible de réaliser des barres magnétiqes de différentes longueurs en combinant des tronçons a1,a2,a3...,an ayant des longueurs élémentaires 11, 12, ..., in prédéterminées ; ceci peut exister pour chaque valeur de section S1 que peut avoir une barre magnétique A1, A2, A3,..., AN, de sorte qu'un opérateur chargé du réglage peut facilement avoir à sa disposition les pièces nécessaires. En outre, dans le cas le plus courant où la position et la dimension des barres magnétiques A1 à AN sont déterminées à l'aide d'un programme de calcul, qui tient compte de la position angulaire prédéterminée P1 à Pn des ouvertures C1 à Cn existantes, ce programme peut tenir compte également de la valeur des différentes longueurs élémentaires I1, I2, I3, . . . , In, ainsi que des différentes valeurs de la section S1 ou premier diamètre d1 selon lesquels ces tronçons a1 à an sont disponibles. Il est à noter que ce premier diamètre d1 peut varier par exemple par de 1 en 1 mm jusqu'au diamètre maximum correspondant au second diamètre d2 que comporte une ouverture C1 à Cn, et qui peut atteindre par exemple 15 mn.

Selon une autre caractéristique de l'invention, une barre magnétique peut être formée d'un ou plusieurs tronçons magnétiques séparés, comme il est représenté sur la figure 2 par la troisième barre magnétique A3 contenue dans la huitième ouverture C8. Dans l'exemple non limitatif décrit, la troisième barre magnétique A3 est constituée par un quatrième et un cinquième tronçons magnétiques a4,a5 séparés par une cale de séparation 40, avec laquelle ils forment un ensemble dont la longueur totale Lt est centrée par rapport au centre d'intérêt O ; mais la troisième barre magnétique A3 peut également être constituée, pour obtenir la correction recherchée, par un nombre plus important de tronçons magnétiques a1, a2, a3, a4, a5,..., an séparés par une ou plusieurs cales séparatrices 40, et formant en outre un ensemble dont la longueur Lt peut être décentrée par rapport au centre d'intérêt O. Les cales séparatrices 40, de même que les cales longitudinales D1,D2 et les cales radiales 20, sont constituées en fibre de verre ou en tout autre matériaux qui n'exercent pas d'influence sur un champ magnétique.

Le dispositif correcteur 10 selon l'invention permet ainsi d'utiliser un nombre N quelconque de barres magnétiques A, A2, ..., AN de composition variée, ce nombre étant limité par le nombre des ouvertures C1 à Cn.

Bien que décrit en référence à l'aimant 2 d'un appareil d'imagerie par résonance magnétique nucléaire, du type de ceux utilisés dans le domaine médical, et dans lequel généralement plusieurs barres magnétiques correctrices sont nécessaires, le dispositif correcteur 10 selon l'invention peut s'appliquer également dans le cas d'aimant d'un type différent. En particulier il est possible d'utiliser l'agencement du dispositif correcteur de l'invention en plaquant une ou des barres magnétiques à l'extérieur d'un aimant, les barres magnétiques n'étant pas dans ce cas formé par des pièces aimantables (en fer doux) mais par des pièces préalablement aimantées de façon permanente, et réalisées en matériau pour aimant permanent, c'est-à-dire en matériau magnétique dur (alliage de terres rares et de cobalt par exemple).

## Revendications

1. Dispositif correcteur d'inhomogénéité d'un champ magnétique ($B_0$) dans un aimant (2), comportant, au moins un élément magnétique (A1,A2,...,AN) de forme longitudinale dont la longueur (L1,Lt) et la section transversale (S1) sont définies en fonction de la correction à effectuer, cet élément magnétique (A1 à AN) étant contenu dans une première ouverture (C1, ...Cn) formée dans un support (1) situé à proximité du champ ($B_0$) à corriger, caractérisé en ce que l'ouverture (C1,...Cn) est formée dans le support (1) par un emplacement réservé lors de la construction du support, l'ouverture (C1,...,Cn) ayant une longueur (L2) et une section transversale (S2) égales ou supérieures respectivement à la longueur maximale et à la section transversale maximale de l'élément magnétique (A1 à An), et en ce qu'il comporte en outre des moyens (20) pour maintenir sensiblement confondus l'axe longitudinal (8) de l'élément magnétique (A,AN) avec l'axe longitudinal (30) de l'ouverture (C1 à Cn).

2. Dispositif correcteur selon la revendication 1, caractérisé en ce qu'il comporte une pluralité d'ouvertures (C1,...,Cn) semblables à la première ouverture (C1) et pré-usinées.

3. Dispositif selon l'une des revendications précédentes, caractérisé en ce que le nombre d'éléments magnétiques (A1,A2,...,AN) est égal ou inférieur au nombre total d'ouvertures (C1,...,Cn).

4. Dispositif correcteur selon l'une des revendications précédentes, caractérisé en ce que les moyens (20) pour maintenir sensiblement confondus les deux axes longitudinaux (8,30) comportent au moins une cale radiale (20) dont la forme extérieure (18) est complémentaire à celle de la seconde section transversale (S2) d'une ouverture (C1 à Cn) et aux mêmes dimensions (d2), la cale radiale (20) comportant une ouverture axiale (19) dans laquelle est engagée un élément magnétique (A1,AN) et dont la section est sensiblement la même que celle de la première section transversale (S1) de l'élément magnétique (A1 à AN).

5. Dispositif correcteur selon l'une des revendications précédentes, caractérisé en ce qu'il comporte en outre au moins deux cales longitudinales (D1,D2) entre lesquelles un élément magnétique (A1,AN) est contenu dans une ouverture (C1 à Cn), l'addition des longueurs (L3,L4) desdites cales longitudinales (D1,D2) avec la longueur (L1,Lt) d'un élément magnétique (A1, An) correspondant à la longueur (L2) d'une ouverture (C1 à Cn).

6. Dispositif correcteur selon la revendication 5, caractérisé en ce que la première et la seconde cales longitudinales (D1, D2 ) comportent des longueurs (L3, L4) égales ou différentes en fonction de la position d'un élément magnétique (A1 à AN) le long de l'axe longitudinal (30) d'une ouverture.

7. Dispositif correcteur selon l'une des revendications précédentes, caractérisé en ce qu'un élément magnétique (A1,A2,...,An) est constitué par au moins deux tronçons magnétiques (a1, a2,..., an) raboutés.

8. Dispositif correcteur selon la revendication 7, caractérisé en ce que la longueur (L1, Lt) d'un élément magnétique (A1 à AN) est obtenue par l'addition de tronçons magnétiques (a1, a2,...,an) ayant des longueurs élémentaires (11,12) différentes.

9. Dispositif correcteur selon la revendication 7, caractérisé en ce qu'un élément magnétique (A1 à AN) est constitué par au moins deux tronçons magnétiques (a1,..., an) séparés par une cale séparatrice (40) en matériau amagnétique.

10. Dispositif correcteur selon l'une des revendications précédentes, caractérisé en ce que l'aimant (2) à la forme d'un cylindre circulaire, et en ce que l'axe longitudinal (30) des ouvertures (C1 à Cn) est parallèle à un axe (Z) de l'aimant (2).

11. Dispositif correcteur selon la revendication 10, caractérisé en ce que les ouvertures (C1 à Cn) et les éléments magnétiques (A1 à AN) sont disposés à l'intérieur de l'aimant (2).

12. Dispositif correcteur selon la revendication 10, caractérisé en ce que les ouvertures (C1 à Cn) sont disposés autour de l'axe (Z) de l'aimant selon des positions angulaires (P1,P2,...,Pn) prédéterminées.

13. Dispositif correcteur selon l'une des revendications précédentes, caractérisé en ce que les éléments magnétiques (A1 à AN) sont en materiau magnétique doux.

14. Dispositif correcteur selon la revendication 13, caractérisé en ce que les éléments magnétiques (A1 à AN) sont en fer doux.

15. Dispositif correcteur selon la revendication 13, caractérisé en ce que les éléments magnétiques (A1 à AN) sont en ferrite doux.

16. Dispositif correcteur selon l'une des revendications 1 à 12, caractérisé en ce que les éléments magnétiques (A1 à AN) sont en matériau magnétique dur préalablement aimanté de façon permanente.

17. Appareil d'imagerie par résonance magnétique nucléaire comportant un aimant équipé du dispositif correcteur selon l'une quelconque des revendications 1 à 16.

**Patentansprüche**

1. Vorrichtung zur Korrektur von Inhomogenitäten eines Magnetfeldes (B$_0$) in einem Magneten (2), mit wenigstens einem magnetischen Element (A1, A2,...,AN) von länglicher Gestalt, dessen Länge (L1, Lt) und dessen Querschnitt (S1) in Abhängigkeit von der auszuführenden Korrektur definiert werden, wobei dieses magnetische Element (A1 bis AN) in einer ersten Öffnung (C1,...,Cn) enthalten ist, die in einem in der Nähe des zu korrigierenden Feldes (B$_0$) angeordneten Träger (1) ausgebildet ist, dadurch gekennzeichnet, daß die Öffnung (C1,...,Cn) im Träger (1) durch einen während des Zusammenbaus des Trägers belegten Raum gebildet wird, wobei die Öffnung (C1,...,Cn) eine Länge (L2) und einen Querschnitt (S2) besitzt, die gleich oder größer als die maximale Länge bzw. der maximale Querschnitt des magnetischen Elementes (Al bis AN) sind, und daß sie außerdem Mittel (20) aufweist, mit denen die Längsachse (8) des magnetischen Elementes (A1 bis AN) mit der Längsachse (30) der Öffnung (C1 bis Cn) im wesentlichen vereinigt gehalten wird.

2. Korrekturvorrichtung gemäß Anspruch 1, dadurch gekennzeichnet, daß sie eine Mehrzahl von Öffnungen (C1,...,Cn) aufweist, die zur ersten Öffnung (C1) ähnlich sind und vorbearbeitet sind.

3. Vorrichtung gemäß einem der vorangehenden Ansprüche, dadurch gekennzeichnet, daß die Anzahl der magnetischen Elemente (A1, A2,...,AN) gleich oder kleiner als die Gesamtzahl der Öffnungen (C1,...,Cn) ist.

4. Korrekturvorrichtung gemäß einem der vorangehenden Ansprüche, dadurch gekennzeichnet, daß die Mittel (20), mit denen die beiden Längsachsen (8, 30) im wesentlichen vereinigt gehalten werden, wenigstens eine radiale Unterstützung (20) aufweisen, deren äußere form (18) zu derjenigen des zweiten Querschnitts (S2) einer Öffnung (C1 bis Cn) komplementär ist und die gleichen Abmessungen (d2) besitzt, wobei die radiale Unterstützung (20) eine axiale Öffnung (19) aufweist, in der ein magnetisches Element (A1, AN) in Eingriff ist und deren Querschnitt im wesentlichen gleich demjenigen des ersten Querschnitts (S1) des magnetischen Elementes (A1 bis AN) ist.

5. Korrekturvorrichtung gemäß einem der vorangehenden Ansprüche, dadurch gekennzeichnet, daß sie außerdem wenigstens zwei longitudinale Unterstützungen (D1, D2) aufweist, zwischen denen ein magnetisches Element (A1, AN) in einer Öffnung (C1 bis Cn) enthalten ist, wobei die Summe der Längen (L3, L4) der longitudinalen Unterstützugen (D1, D2) und der Länge (L1, Lt) eines magnetischen Elementes (A1, AN) der Länge (L2) einer Öffnung (C1 bis Cn) entspricht.

6. Korrekturvorrichtung gemäß Anspruch 5, dadurch gekennzeichnet, daß die erste und die zweite longitudinale Unterstützung (D1, D2) Längen (L3, L4) besitzen, die in Abhängigkeit von der Position eines magnetischen Elementes (A1 bis AN) gleich oder verschieden von der Länge der Längsachse (30) einer Öffnung sind.

7. Korrekturvorrichtung gemäß einem der vorangehenden Ansprüche, dadurch gekennzeichnet, daß ein magnetisches Element (A1, A2,...,AN) durch wenigstens zwei aneinander gefügte magnetische Teilstücke (a1, a2,...,an) gebildet wird.

8. Korrekturvorrichtung gemäß Anspruch 7, dadurch gekennzeichnet, daß die Länge (L1, Lt) eines magnetischen Elementes (A1 bis AN) durch die Aneinanderfügung der magnetischen Teilstücke (a1, a2,...,an), die verschiedene Elementarlängen (11, 12) besitzen, erhalten wird.

9. Korrekturvorrichtung gemäß Anspruch 7, dadurch gekennzeichnet, daß ein magnetisches Element (A1 bis AN) durch wenigstens zwei magnetische Teilstücke (a1,...,an) gebildet wird, die durch eine trennende Unterstützung (40) aus nichtmagnetischem Material getrennt sind.

10. Korrekturvorrichtung gemäß einem der vorangehenden Ansprüche, dadurch gekennzeichnet, daß der Magnet (2) die form eines kreisförmigen Zylinders besitzt und daß die Längsachse (30) der Öffnungen (C1 bis Cn) parallel zu einer Mittellinie (Z) des Magneten (2) ist.

11. Korrekturvorrichtung gemäß Anspruch 10, dadurch gekennzeichnet, daß die Öffnungen (C1 bis Cn) und die magnetischen Elemente (A1 bis AN) im Inneren des Magneten (2) angeordnet sind.

12. Korrekturvorrichtung gemäß Anspruch 10, dadurch gekennzeichent, daß die Öffnungen (C1 bis Cn) um die Mittellinie (Z) des Magneten an vorgegebenen Winkelpositionen (P1, P2,...,Pn) angeordnet sind.

13. Korrekturvorrichtung gemäß einem der vorangehenden Ansprüche, dadurch gekennzeichnet, daß die magnetischen Elemente (A1 bis AN) aus weichmagnetischem Material sind.

14. Korrekturvorrichtung gemäß Anspruch 13, dadurch gekennzeichnet, daß die magnetischen Elemente (A1 bis AN) aus Weicheisen sind.

15. Korrekturvorrichtung gemäß Anspruch 13, dadurch gekennzeichnet, daß die magnetischen Elemente (A1 bis AN) aus weichmagnetischem Ferrit sind.

16. Korrekturvorrichtung gemäß einem der Ansprüche 1 bis 13, dadurch gekennzeichnet, daß die magnetischen Elemente (A1 bis AN) aus hartmagnetischem Material sind, das im voraus permanent magnetisiert worden ist.

17. Gerät zur Bilderzeugung mittels kernmagnetischer Resonanz, das einen Magneten aufweist, der mit einer Korrekturvorrichtung gemäß einem der Ansprüche 1 bis 16 ausgerüstet ist.

# Claims

1. An inhomogeneity correcting device for a magnetic field ($B_0$) in a magnet (2) comprising at least one magnetic element (A1, A2,...AN) with a longitudinal form whose length (L1, Lt) and the transverse section (S1) are defined as a function of the correction to be made, said magnetic element (A1 through AN) being contained in a first opening (C1,...,Cn) formed in a support (1) arranged near the field ($B_0$) to be corrected, characterized in that the opening (C1,...,Cn) is formed in the support (1) by a placement reserved at the time of the construction of the support, the opening (C1,...,Cn) having a length (L2) and a transverse section (S2) equal to or greater than, respectively, the maximum length and the maximum transverse section of the magnetic element (A1 through An), and in that it furthermore comprises means (20) in order essentially to maintain together the axis (8) of the magnetic element (A and AN) and the longitudinal axis (30) of the opening (C1 through Cn).

2. The correcting device as claimed in claim 1, characterized in that it comprises a plurality of openings (C1,...,Cn) which are similar to the first opening (C1) and are pre-machined.

3. The device as claimed in claim 1 or claim 2, characterized in that the number of magnetic elements (A1, A2,...,An) is equal to the total number of openings (C1,...,Cn).

4. The correcting device as claimed in any one of the preceding claims, characterized in that the means (20) to maintain essentially together the two longitudinal axes (8 and 30) comprise at least one radial bolster (20) whose outside form (18) is complementary to the form of the second transverse section (S2) of an opening (C1 through Cn) and to the same dimensions (d2), the radial bolster (20) comprising an axial opening (19) in which there is fitted a magnetic element (A1 and AN) and whose section is essentially equal to that of the first transverse section (S1) of the magnetic element (A1 through AN).

5. The correcting device as claimed in any one of the preceding claims, characterized in that it furthermore comprises at least two longitudinal bolsters (D1 and D2) between which a magnetic element (A1 and AN) is contained in an opening (C1 through Cn), the sum of the lengths (L3 and L4) of the said longitudinal bolster (D1 and D2) and the length (L1 and Lt) of a magnetic element (A1 and An) corresponding to the length (L2) of an opening (C1 through Cn).

6. The correcting device as claimed in claim 5, characterized in that the first and the second longitudinal bolsters (D1 and D2) have the same or different lengths a function of the position of a magnetic element (A1 through AN) along the longitudinal axis (30) of an opening.

7. The correcting device as claimed in any one of the preceding claims, characterized in that a magnetic element is constituted by at least two magnetic stumps (a1, a2,...,an) arranged end to end.

8. The correcting device as claimed in claim 7, characterized in that the length (L1 and Lt) of a magnetic element (A1 through AN) is produced by putting together magnetic stumps (a1, a2,...,an) having different unit lengths (11 and 12).

9. The correcting device as claimed in claim 7, characterized in that a magnetic element (A1 through AN) is constituted by at least two magnetic stumps (a1,...,an) separated by a spacing bolster (40) of nonmagnetic material.

10. The correcting device as claimed in any one of the preceding claims, characterized in that the magnet (2) has the form of a circular cylinder, and in that the longitudinal axis (30) of the openings (C1 through Cn) is parallel to an axis (Z) of the magnet (2).

11. The correcting device as claimed in claim 10, characterized in that the openings (C1 through Cn) and the magnetic elements (A1 through AN) are arranged inside the magnet (2).

12. The correcting device as claimed in claim 10, characterized in that the openings (C1 through Cn) are arranged around the axis (Z) of the magnet in accordance with predetermined angular positions (P1, P2,..., Pn).

13. The correcting device as claimed in any one of the preceding claims, characterized in that the magnetic elements (A1 through AN) are made of a soft magnetic material.

14. The correcting device as claimed in claim 13, characterized in that the magnetic elements (A1 through AN) are made of soft iron.

15. The correcting device as claimed in claim 13, characterized in that the magnetic elements (A1 through AN) are made of soft ferrite.

16. The correcting device as claimed in any one of the preceding claims 1 through 12, characterized in that the magnetic elements (A1 through AN) are made of a hard magnetic material, which is previously permanently magnetized.

17. An image forming device using nuclear magnetic resonance, comprising a magnet fitted with the correcting device as claimed in any one of the preceding claims 1 through 16.

FIG_1

EP 0 346 333 B1

# FIG_2

EP 0 346 333 B1